# EUROPEAN PATENT APPLICATION

(11) **EP 4 119 925 A1**
(43) Date of publication of application: **18.01.2023**
(21) Application number: 21767610.5
(22) Date of filing: 08.02.2021
(51) Int. Cl.: G01N 17/00, G01N 27/80

(54) **DEVICE AND METHOD**

(30) Priority: 11.03.2020 JP 2020041607; 18.05.2020 JP 2020087042
(71) Applicant: Yokogawa Electric Corporation, Musashino-shi, Tokyo 180-8750 (JP)
(72) Inventor: OKABE Nobuo, Musashino-shi, Tokyo 180-8750 (JP); BLAKELEY Philip, Cambridgeshire, CB21 4QQ (GB); LADDHA Chetan, Woking, Surrey, GU22 9AG (GB)
(74) Representative: Winter, Brandl - Partnerschaft mbB
(86) International application number: PCT/JP2021/004653
(87) International publication number: WO 2021/181978

(57) **Abstract**

Here is described an apparatus for measuring and/or monitoring a strength of a magnetic field inside a sample including: a fixing unit made of a non-magnetic material; a magnetic field strength measuring device having a sensor; and a first elongated member and a second elongated member. The elongated members are made of a material having a high relative magnetic permeability, and each of the elongated members has a first end portion and a second end portion. The fixing unit is configured to support the elongated members in a fixed posture such that the first end portion of the first elongated member and the first end portion of the second elongated member are positioned opposite to each other to form a gap, and the fixing unit is configured to support the sensor of the measuring device inside the gap or substantially inside the gap.

## Description

### BACKGROUND

### 1. TECHNICAL FIELD

The present invention relates to an apparatus for measuring a strength of a magnetic field inside a sample of a ferromagnetic material. The present invention further provides a method for measuring a strength of a magnetic field inside a sample in a non-destructive manner.

### 2. RELATED ART

Monitoring subsea equipment is an important role for oil companies and gas companies. This is because the failure of the equipment can have catastrophic consequences. One of such examples is monitoring corrosion of subsea pipelines. Subsea pipelines exist in a trench in the seabed or are embedded inside the seabed and transport substances such as oil, gas, or water.

The size and material of the pipelines vary depending on the application to be used. The diameter of the pipeline is 50 mm to 2 m and the thickness of the wall is 10 mm to 75 mm. The pipe can exist in the seabed for up to 20 years to always serve the purpose, and thus the pipe is necessarily made of a strong and durable material. For this reason, the pipelines are usually made of high yield strength steel which is essentially ferrite and thus can be magnetized.

One of the threats to pipeline life is corrosion, particularly, internal corrosion. When corrosion occurs outside the pipe, the pipe can be easily inspected. However, the internal corrosion is considerably difficult to monitor. In particular, local corrosion is a specific threat. This is because the local corrosion is more rapid than general corrosion and has non-uniform growth characteristics, which makes it difficult to predict.

When inspecting pipes, a non-destructive testing technique is preferable over a destructive testing technique. This is because the non-destructive testing technique does not cause any disturbance to a flow in the pipe. Existing techniques include eddy currents and flux leakage. However, in these techniques, a large amount of power is required for operation. Furthermore, in the existing techniques, a large amount of data is generated and is inappropriate for being left as it is for a long period of time, and thus, it is almost impossible to use the existing techniques in the seabed for the purpose of constant monitoring. The use of ultrasonic sensors for constant monitoring has developed over the years. However, scalability of ultrasonic waves for covering a large area of the pipe surface is difficult, and an ultrasonic sensor grid is not effective for monitoring local deterioration. Another problem of the ultrasound-based seabed monitoring technique is that a unit component cost pushes up the overall cost of the equipment, which makes it impossible to dispose a plurality of pieces of sensor equipment to sufficiently cover high risk locations.

In addition to the above, the existing technique for measuring corrosion is not suitable for installation for a long period of time, that is, over 20 years, for many reasons. Many reasons are a constant need for a large amount of power, a periodic need for interaction with divers or robots, an inability of existing components to operate for such a long period of time, an inability of existing components to operate under a high pressure, a need for consumables which are not easily available, and an inability of existing components to operate over a wide temperature range (0 to 80 degrees Celsius).

The subsea pipeline can be inspected internally with a pig passing along the interior of the pipeline (in-pipe inspection). These devices perform a flux leakage method and/or an ultrasonic method. However, a main drawback of these techniques is that the pipe is necessarily "pigable", that is, there are necessarily no obstacles in the pipe, and the geometry of the pipe necessarily has an appropriate shape, for example.

Therefore, depending on the states of the subsea pipeline and other such structures, the available data is considerably limited due to the high cost and complexity of the equipment required to monitor the states. This is because the equipment needs to withstand a difficult environment on the seabed.

Currently, there is no method to provide a continuous measurement of a magnetic field in a pipe wall. Furthermore, generally, there is no method to measure a magnetic field inside a magnetized material.

Therefore, there is a need for a system capable of directly monitoring the state of the thickness of a wall of a ferrite material as it is in a non-destructive manner. The system is necessarily able to function unlimitedly without primary intervention and without requiring a large amount of energy.

Therefore, an object of the present invention is to provide a new measuring device for ferrite materials capable of monitoring/measuring a strength of a magnetic field inside a ferrite material.

Although the above problems have been related to subsea pipelines, the present invention is not limited to such an application. The present invention can be applied to any device/structure that acquires the measurement value of a magnetic flux density inside a sample.

### GENERAL DISCLOSURE

According to a first aspect of the present invention, there is provided an apparatus for measuring a strength of a magnetic field inside a sample. The apparatus may include a fixing unit made of a non-magnetic material. The apparatus may include a magnetic field strength measuring device having a sensor. The apparatus may include a first elongated member and a second elongated member. The elongated members may be made of a material having a high relative magnetic permeability. Each of the elongated members may have a first end portion and a second end portion. The fixing unit may be configured to support the elongated members in a fixed posture such that the first end portion of the first elongated member and the first end portion of the second elongated member are positioned opposite to each other to form a gap. A housing may be configured to support the sensor of the measuring device inside the gap or substantially inside the gap. The sample may be made of a ferromagnetic material. Each of the elongated members may be disposed to exist on a surface of the sample or to be adjacent to the surface of the sample.

The fixing unit can be a housing. The fixing unit can be temporary or permanent. The fixing unit can be a non-magnetic bolt or clamp. The fixing unit can be a weld portion or an adhesive.

Each of the elongated members can have a longitudinal axis. A center of the longitudinal axis is substantially aligned with a center of a longitudinal axis of another elongated member. This ensures that the measured magnetic field is in only one direction. The longitudinal axis can extend from the first end portion to the second end portion of each of the elongated members.

The longitudinal axis of the elongated member can be aligned with a longitudinal axis of the sample.

The elongated member may be made of a material, such as Hiperco 50 and Hiperco 50A, which also has a low relative residual magnetism, for example, less than about 100 microtesla.

The first end portion of the elongated member can include a tapered portion for reducing an area of a cross section of the elongated member to be the same or substantially the same as an area of a cross section of the sensor on the magnetic field strength measuring device. This is to concentrate the magnetic field through the area of the small cross section, which causes the sensor to pick up a higher read value. This enables more accurate reading. Note that in the present invention, the actual value of the magnetic field in the pipe wall is not measured, but a value proportional to the actual value is measured. This is due to the surprising technical effect that the strength of the magnetic field inside the sample is proportional to the strength of the magnetic field inside the elongated member. Whether the proportional relationship is constant depends on the shape of the elongated component. Thus, by increasing the area of contact with the surface to be measured and/or by reducing the area of the cross section, the constancy of the proportional relationship is increased.

The magnetic field strength measuring device can have a Hall effect sensor. Alternatively, the magnetic field strength measuring device can have a magnetoresistive sensor or any other form of magnetometer.

The housing can have at least one connection portion suitable for connecting cables. The housing can have a plurality of connection portions for connecting cables. The connection portion of the housing can be sealed to prevent water intrusion. As long as the elongated member and the magnetic field strength measuring device are held in a fixed position, the housing may not be necessary.

The sample can be a metal conduit such as a pipe. The sample can be any ferrite material. The sample can have any shape and size. Ideally, the sample is necessarily at least two to three times larger than the present apparatus for accurate reading.

The housing and the elongated member can be attached to the sample. Alternatively, the apparatus can be disposed on the sample. The apparatus can be permanently fixed to the sample. The apparatus can be fixed via screws, adhesive, or any type of fastening mechanism. An array of apparatuses fixed to the sample can exist to measure different magnetic field strengths over the entire sample. The apparatuses can be disposed in different directions to measure the magnetic field strength of the sample in different directions. The array can provide a detailed data set of sample states. There can be additional monitoring devices disposed near the apparatus of the present invention. Such additional devices can be used to measure the magnitude and direction of the magnetic field emitted from the surface of the sample. These additional monitoring devices can be calibrated by reference to the value of the magnetic field inside the sample as described according to the present invention.

The measuring device can measure a magnetic field strength of about 0 to +/-15000 Gauss or up to a magnetic saturation level of the sample. In addition, the measuring device can also measure the magnetic field as a positive or negative value, which indicates the direction of the magnetic flux inside the sample, over a sample range.

Each of the first elongated member and the second elongated member may have a contact surface in surface contact with the sample on a side closer to the second end portion than the first end portion.

Each of the first elongated member and the second elongated member may have an extending portion which extends away from the sample between the first end portion and the second end portion. The extending portion may be spaced further away from the sample as the extending portion is closer to the first end portion.

The first elongated member and the second elongated member may be wider at the contact surface compared with the extending portion.

The contact surface may be curved in a width direction of the first elongated member or the second elongated member having the contact surface.

The contact surface may be curved in a length direction of the first elongated member or the second elongated member having the contact surface. A magnetic resistance between the contact surface of the first elongated member and the contact surface of the second elongated member in the apparatus may be smaller than a magnetic resistance between the contact surface of the first elongated member and the contact surface of the second elongated member in the sample.

The apparatus may further include a transmission unit configured to transmit measurement data of the magnetic field strength measuring device. The permeability of the first elongated member and the second elongated member may be higher than the permeability of the sample.

According to a second aspect of the present invention, there is provided a method for measuring and monitoring a strength of a magnetic field inside a sample. The method may include attaching or disposing the apparatus according to the first aspect of the present invention on the sample. The method may include measuring a strength of a magnetic field through the elongated member by using the magnetic field strength measuring device. The method may include monitoring a value of the strength of the magnetic field through the sample by monitoring a value of the strength of the magnetic field through the elongated member.

The above-described method provides a non-destructive manner for measuring and monitoring the strength and direction of the magnetic field inside the sample. By using the surprising fact that there is the proportional relationship between the strength of the magnetic field inside the sample and the strength of the magnetic field inside the elongated member, the strength of the magnetic field inside the sample can be calculated by measuring the strength of the magnetic field inside the elongated member. A "constant coefficient" in the relationship can be determined physically or via computer modeling.

The method described above can allow the calibration of other devices intended to determine corrosion inside the pipeline. When a large increase in the magnetic field outside the pipe is detected, it is necessary to know whether the increase is caused by shallow corrosion combined with high internal magnetization or by deep corrosion caused by low internal magnetization.

The method can further include establishing a relationship between the strength of the magnetic field in the elongated member and the strength of the magnetic field in the sample. This can be performed via computer modeling or experimentation. The measuring and the monitoring the strength of the magnetic field inside the sample may be performed to monitor an area of a cross section of the sample.

The apparatus can be attached to the sample in a state where a longitudinal axis of the elongated member is aligned with a first axis of the sample, so that the strength of the magnetic field through the sample is measured and monitored in the same direction as the first axis. The direction of the magnetic field in the sample measured by the apparatus is defined by the longitudinal axis of the apparatus. When measuring the magnetic field in the pipe wall surface, an apparatus may be attached in a direction intersecting the axial direction of the pipe to measure the circumferential magnetic field component inside the pipe. When fitted along the pipe, the apparatus measures the components of the magnetic field along the pipe.

According to a third aspect of the present invention, there is provided a method in which in the method of measuring and monitoring the strength of the magnetic field inside the sample according to the second aspect of the present invention, a plurality of apparatuses are used to measure the magnetic field strength in various directions and orientations.

According to a fourth aspect of the present invention, there is provided a measurement system including a plurality of apparatuses according to the first aspect of the present invention. These apparatuses can be disposed inside a mold. The apparatuses can be disposed to measure the strength of the magnetic field inside the sample in a longitudinal direction and in a direction perpendicular to the longitudinal direction. There can be the plurality of apparatuses disposed at various locations around the sample. For example, when this example is a pipeline, there can be four to six apparatuses disposed at equal intervals around the circumference of the pipeline.

Any further features disclosed in relation to each aspect of the present invention correspond to any further features of other aspects of the present invention.

### BRIEF DESCRIPTION OF THE DRAWINGS

Here, the present invention is described with reference to the accompanying drawings without limiting exemplary embodiments.
Fig. 1 illustrates a perspective view of an apparatus according to an embodiment of the present invention.
Fig. 2 illustrates a plan view of the apparatus of Fig. 1.
Fig. 3 illustrates a side view of the apparatus in Figs. 1 and 2.
Fig. 4 illustrates molds including two embodiments of the apparatus and positioned perpendicular to each other.
Fig. 5 illustrates a first end portion of a first elongated member according to the present invention.
Fig. 6 illustrates an exemplary magnetic field strength measuring device according to the embodiment of the present invention.
Fig. 7 is a graph illustrating a relationship between a magnetic field strength in the apparatus according to the present invention and a magnetic field strength in a sample under measurement.

### DESCRIPTION OF EXEMPLARY EMBODIMENTS

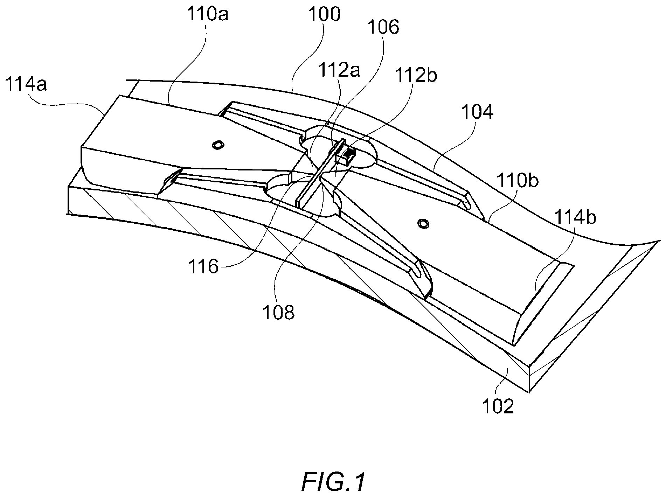

Fig. 1 illustrates a perspective view of an apparatus 100 according to an embodiment of the present invention. The apparatus 100 is illustrated with a housing 104, a magnetic field strength measuring device 106 and two elongated members 110a/b. The apparatus 100 is illustrated to be fit for a curved sample 102 such as a pipeline (also referred to as a pipe). This is not to be construed as limited. This is because the apparatus 100 can be used on the sample 102 of any shape/geometry. The sample 102 can be a cuboid, a flat plate, a hexagon, a triangle, or any such shape. In addition, the sample 102 may be made of any material that can be magnetized and measured, and may be made of a metal material as an example.

Each elongated member 110a/b has a first end portion 112a/b and a second end portion 114a/b. The elongated member 1 10a/b is typically made of a material having a high relative magnetic permeability greater than 500 (which is a ratio between a transmittance of a medium and a transmittance of a free space, so a unit is dimensionless). When the elongated member 110a/b has a high relative magnetic permeability, the elongated member can be magnetized rapidly from a sample. The permeability of the elongated member 1 10a/b may be higher than the permeability of the pipeline sample 102. As a result, when the elongated member 110a is disposed on the surface of the sample 102, a magnetic flux flows from the surface of the pipeline sample 102 into the elongated member 110a/b.

Additionally, the elongated member 1 10a/b may be made of a material having a low relative residual magnetism which is typically less than 100 microtesla. When the elongated member 110a/b has a low relative residual magnetism, the elongated member can be demagnetized, and any large residual magnetism is prevented from being magnetized. This is important for accurate measurement of a magnetic field strength.

The elongated member 1 10a/b illustrated in Fig. 1 has a length of about 150 mm and a width of about 25 mm, and has a tapered shape having a width of about 3 mm. A gap 116 has a width of about 3 mm. The total height of the apparatus 100 above the sample 102 is about 10 mm.

The housing 104 is necessarily made of a non-magnetic material not to interfere with the accuracy of the apparatus 100. The main purpose of the housing 104 is to direct the elongated member 110a/b with a fixed posture to form the gap 116. The size of the gap 116 is an important feature of the present invention and is necessarily maintained to ensure the accuracy of a measurement result. The gap 116 is formed substantially between the first end portion 112a of the first elongated member 110a and the first end portion 112b of the second elongated member 110b. The gap 116 is suitable for fitting the magnetic field strength measuring device 106 thereinto. The housing 104 fixes the magnetic field strength measuring device 106 in a fixed position with respect to the gap 116 while disposing the sensor 108 of the magnetic field strength measuring device 106 inside the gap 116 or substantially inside the gap 116. Typically, the gap is 2 mm or is sufficient to allow the fitting of the magnetic field sensor.

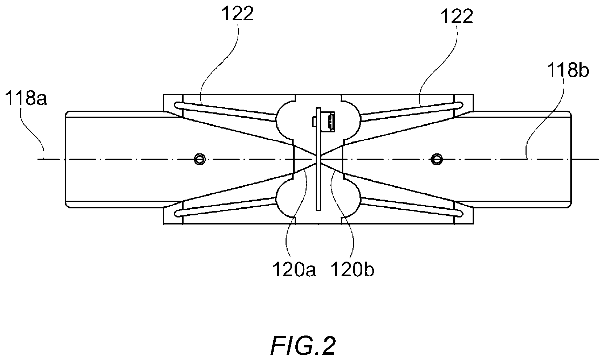

In the housing 104, the elongated members 1 10a/b can be disposed such that the elongated members 110a/b exist on the surface of the sample 102 or adjacent to the surface of the sample 102. As can be seen in Fig. 2, the elongated members 110a/b have longitudinal axes 118a/b, respectively. In the first elongated member 110a, the longitudinal axis 118a extends through the first end portion 112a to the second end portion 114a. In the second elongated member 110b, the longitudinal axis 118b extends through the first end portion 112b to the second end portion 114b. In Fig. 2, in the housing 104, the elongated members 110a are disposed such that the longitudinal axes 118a/b are parallel to each other and pass through the same point. It is preferable that the entire elongated member 110a/b is aligned with respect to the apparatus to function accurately. Incidentally, as long as the central axis of the first end portion 112a and the central axis of the first end portion 112b coincide with each other, the other portions of the elongated members 110a/b may not be disposed on the same straight line.

When the apparatus 100 is disposed on the sample 102, the elongated member 1 10a/b is magnetized (due to its high relative transmittance) by the sample 102 which is generally at least two to three times larger than the elongated member 110a/b. The strength of magnetism along the longitudinal axis 118a/b of the elongated member 110a/b is proportional to the strength of magnetism of the sample 102 along the parallel axis. Due to this, the strength of the magnetic field through the sample 102 is proportional to the strength of the magnetic field through the elongated member 110a/b. Since the gap 116 between the elongated members 110a/b is small, the magnetic field can pass through the gap 116 and be measured by the sensor 108 on the magnetic field strength measuring device 106. The magnetic field strength measuring device 106 is used to measure the magnetic flux through the gap 116 which generates the magnetic flux through the elongated member 110a/b. By using this value, the magnetic flux through the sample 102 can be calculated by correlating the measurement value through the elongated member 110a/b with the sample 102. The present invention can be used to indicate a static magnetic field rather than an alternating magnetic field. The magnetic field measured according to the present invention needs to be constant during the reading, for example, for one second.

The phenomenon described above is not well-known in the art and provides a non-destructive manner for measuring the strength of the magnetic field inside the sample 102 without interfering with the sample 102 itself. The apparatus 100 described in the present specification is disposed on the sample 102 and can be used to monitor and measure the magnetic field strength in an easy manner.

Whether the proportional relationship is constant depends on the dimensions of the first elongated member 110a and the second elongated member 110b and, to a relatively lesser extent, the thickness of the sample 102. Whether the proportional relationship is constant can be determined by physical experimentation or by a computer modeling the apparatus 100 with respect to the sample 102. Therefore, the apparatus 100 provides a method of determining a magnetic flux density inside the material of the magnetized sample 102.

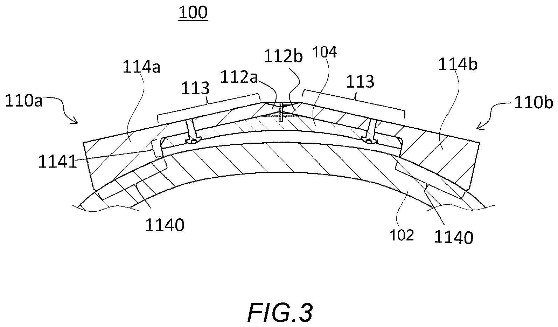

Fig. 3 illustrates a side view of the apparatus in Figs. 1 and 2. The apparatus 100 is disposed to be fit for the semi-circular sample 102 such as a pipeline. The bottom surface of each elongated member 110a/b is shaped to exist along the lateral axis of the pipeline sample 102. In this arrangement, the apparatus 100 can measure the magnetic flux laterally through the pipeline sample 102.

For example, the elongated members 110a/b may have contact surfaces 1140, which are in surface contact with the pipeline sample 102, at the second end portions 114a/b, respectively. As a result, the magnetic flux can reliably flow from the surface of the pipeline sample 102 to the magnetic field strength measuring device 106 via the elongated member 110a/b. However, the contact surface 1140 may not necessarily be provided on the second end portion 114a/b as long as the contact surface is provided on the side closer to the second end portion 114a/b than the first end portion 112a/b.

The contact surface 1140 may be curved in the width direction (in the present embodiment, the lateral direction of the pipeline sample as an example) of the elongated member 110a or the elongated member 110b having the contact surface 1140. As a result, the elongated member 110a/b can be disposed along the surface of the pipeline sample 102 in the lateral axis direction of the pipeline sample 102.

As can be easily assumed, when the apparatus 100 is directed along the longitudinal axis of the pipeline sample 102, the bottom surface of the elongated member 110a/b does not need to be curved appropriately. In this case, the contact surface 1140 may be curved in the length direction of the elongated member 110a or the elongated member 110b having the contact surface 1140, that is, in the longitudinal axis direction of the pipeline sample 102.

The elongated members 110a/b may have extending portions 113, which extend away from the pipeline sample 102, between the first end portions 112a/b and the second end portions 114a/b, respectively. As a result, it is possible to prevent that the magnetic flux flowing from the pipeline sample 102 into the elongated member 110a/b via the contact surface 1140 returns to the pipeline sample 102, and thus the magnetic flux can be reliably passed through the magnetic field strength measuring device 106 to measure the magnetic field strength.

In the present embodiment, a rising surface 1141 is provided between the bottom surface (that is, the surface on the pipeline sample 102 side) of the extending portion 113 and the contact surface 1140, whereby the extending portion 113 is reliably spaced away from the pipeline sample 102. However, the bottom surface of the extending portion 113 (that is, the surface on the pipeline sample 102 side) and the contact surface 1140 may be continuous, or may be directly adjacent to each other without interposing a rising surface, a notch, or the like.

The extending portion 113 may have a continuous shape in an extending direction. For example, in the cross section of the extending portion 113 along the extending direction, each of the bottom surface of the extending portion 113 and the opposite surface (also referred to as a top surface) may be tangentially continuous at each adjacent point. As a result, the magnetic flux flowing from the pipeline sample 102 into the elongated member 110a/b through the contact surface 1140 is prevented from leaking out of the elongated member 1 10a/b through the surface of the extending portion 113.

The bottom surface of the extending portion 113 may be a flat surface or a curved surface. When the bottom surface of the extending portion 113 is a curved surface, the bottom surface may be curved in the length direction of the elongated member 1 10a/b or may be curved in the width direction.

The top surface of the extending portion 113 may be a flat surface or a curved surface. When the top surface of the extending portion 113 is a curved surface, the bottom surface may be curved in the length direction of the elongated member 1 10a/b or may be curved in the width direction.

The extending portion 113 may be further spaced away from the pipeline sample 102 as the extending portion is closer to the first end portion 112a/b (the end portion on the gap 116 side). As a result, it is possible to reliably prevent that the magnetic flux flowing from the pipeline sample 102 into the elongated member 110a/b via the contact surface 1140 returns to the pipeline sample 102.

Here, the elongated member 1 10a/b may be wider at the contact surface 1140 compared to the extending portion 113. As a result, the magnetic flux can reliably flow from the surface of the pipeline sample 102 to the elongated member 1 10a/b. Note that the width of the elongated member 110a/b may be a dimension in a direction orthogonal to the length direction (the longitudinal axis direction of the pipeline sample 102 as an example in the present embodiment) of the elongated member 1 10a/b. The width of the elongated member 1 10a/b at the contact surface 1140 may be the width of the contact area of the contact surface 1140 with the pipeline sample 102.

A magnetic resistance between the contact surface 1140 of the elongated member 110a and the contact surface 1140 of the elongated member 110b in the apparatus 100 may be smaller than a magnetic resistance between the contact surface 1140 of the elongated member 110a and the contact surface 1140 of the elongated member 110b in the pipeline sample 102. Also in this case, the magnetic flux can more reliably flow from the surface of the pipeline sample 102 to the elongated member.

The housing 104 may connect the extending portion 113 of the elongated member 110a and the extending portion 113 of the elongated member 110b. For example, the housing 104 may extend in the length direction of the elongated members 110a/b and be combined to each of the extending portions 113a/b to set a state where the elongated members 1 10a/b are fixed to each other. The housing 104 may be combined to the extending portion 113a/b via an adhesive or via a mechanical fastener such as a strap or a screw. The screw combining the housing 104 and the extending portion 113 may be formed from a non-magnetic material so as not to interfere with the accuracy of the apparatus 100.

The housing 104 may be disposed on the pipeline sample 102 side with respect to the elongated member 110a/b. In the present embodiment, as an example, the housing 104 is disposed between the extending portion 113 and the pipeline sample 102, and a void is provided between the housing 104 and the pipeline sample 102. However, the housing 104 may be disposed on the opposite side of the elongated member 110a/b to the pipeline sample 102.

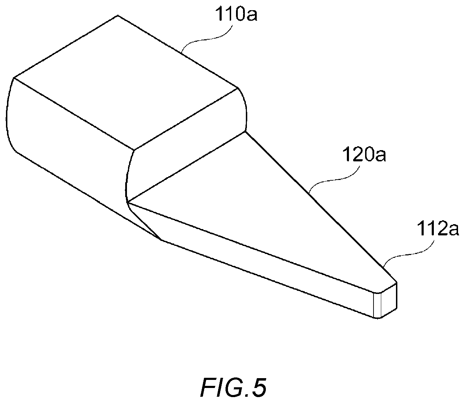

As best seen in Figs. 1, 2, and 5, the first end portion 112a/b of the elongated member 110a/b includes a tapered portion 120a/b. The tapered portion 120a/b may have a tapered shape that becomes thinner toward the gap 116. By the tapered portion, the area of the cross section of the elongated members 1 10a/b is reduced to an area which is the same or substantially the same as the area of the cross section of the sensor 108 on the magnetic field strength measuring device 106. As an example, the area of the end surface of the elongated member 1 10a/b on the gap 116 side may be the same as the area of the sensor 108 on the magnetic field strength measuring device 106. As a result, an additional benefit is provided which amplifies the magnetic field strength received by the sensor 108 on the magnetic field strength measuring device 106. It is desirable that the area of the cross section of the narrow end portion of the elongated member is slightly larger than the magnetic field sensor such that the sensor is not affected by the edge effect of the elongated member where the magnetic field may be weaker. As a result, the magnetic field concentrates on a smaller cross section, and a higher read value through the sensor 108 is obtained, thereby increasing the accuracy of the measurement. For example, by the tapered portion 120a/b, the area can be reduced to a square of about 3 mm×3 mm in the sensor 108 which is a square of about 2 mm×2 mm. The depth of the gap 116 is about 1 mm, but can be at least wide enough to fit the sensor 108. The tapered portion 120a/b can have different sizes depending on the size of the sensor 108. When the elongated member 1 10a/b has a small area of the cross section, no tapered portion may be required. The shape of the tapered portion 120a/b in these drawings is not to be construed as limited. This is because the area of the cross section can be reduced by the elongated member 110a/b by any manner.

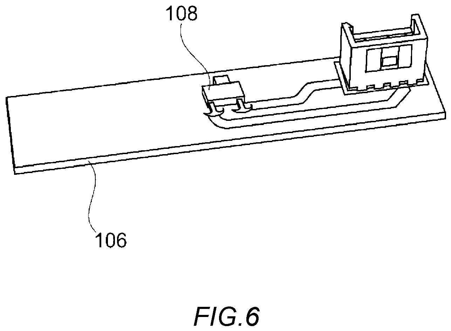

The magnetic field strength measuring device 106 illustrated in Figs. 1 to 3 and Fig. 6 can have a Hall effect sensor. The circuit board illustrated in Fig. 6 is designed such that the Hall effect sensor is disposed in the gap between the two elongated members of the bridge. The Hall effect sensor generates a voltage gradient in a direct proportional relationship in the presence of a magnetic field. Thus, when the strength of the magnetic field increases, the voltage output increases. A terminal to which a cable can be plugged is attached to the magnetic field strength measuring device 106 illustrated in Figs. 1 to 3. These cables can extend from the magnetic field strength measuring device 106 to a control unit (not illustrated) via a connection portion 122 for cables. The control unit receives voltage data from the Hall effect sensor and converts the voltage data into magnetic field strength data. In addition, the cable reaching the magnetic field strength measuring device 106 can supply power to the magnetic field strength measuring device 106. The power can be supplied from any power source such as a battery or a thermal power generation device.

The apparatus 100 can be permanently fixed to the sample 102. The apparatus 100 can be fixed via an adhesive or via a mechanical fastener such as a strap or a screw. When the apparatus 100 is fixed to the sample 102 with a screw, the permeability of the screw may be equal to or higher than the permeability of the sample 102 or lower than the permeability of the sample 102. As an example, the screw may be formed of the same material as the sample 102 or may be formed of the same material as the elongated member 1 10a/b. In addition, the apparatus 100 can be simply disposed on the sample 102 without any attachment.

For example, when the apparatus 100 monitors the magnetic flux through the steel wall of a pipe in the seabed, a plurality of apparatuses 100 can be fixed to the pipe at various locations of the pipe. The plurality of apparatuses 100 can be fixed to the pipe even in different orientations. Before the pipe is disposed, the apparatus 100 is fixed to the pipe and connected to an appropriate controller and a power source. The read values of the magnetic flux are acquired at all locations, and all values of the magnetic field strength measuring devices 106 are set/calibrated to zero. Then, the pipe is disposed in the seabed. Over time, the interior of the pipe corrodes and erodes, so that the area of the cross section of the pipe or the thickness of the wall of the pipe is reduced. This reduction changes the strength of the magnetic field through the pipe, and thus the strength of the magnetic field through the elongated member 1 10a/b is changed. Electronic equipment on the apparatus 100 can be switched periodically at constant intervals to monitor the state of the pipe. Thus, this difference in magnetic field strength can be correlated with a computer simulation model or experimental model to indicate the thickness of a new wall of the pipe. This wall thickness favorably indicates the state of the pipe and when the pipe can need to be replaced.

Instead of switching the electronic equipment on the apparatus 100, a transmission unit (not illustrated) which transmits the measurement data of the magnetic field strength measuring device 106 may be provided in the apparatus 100. The transmission unit may be controlled by the above-described control unit. The transmission unit may transmit data by wired communication or may transmit data by wireless communication. When the transmission unit transmits data by wired communication, each apparatus 100 provided in the pipeline sample 102 may be connected to a relay apparatus or a pipe state monitoring apparatus by a communication cable. When the transmission unit transmits data by wireless communication, an unmanned submarine may patrol the vicinity of each apparatus 100 and collect data.

The above example is applied to a subsea pipe. However, as should be easily assumed, the described apparatus 100 and method can be applied to any geometry or sample, which is not easily analyzable, such as a pipe above the water surface and a pipe embedded under the ground. In addition, the apparatus 100 can also be retrofitted to the sample, for example.

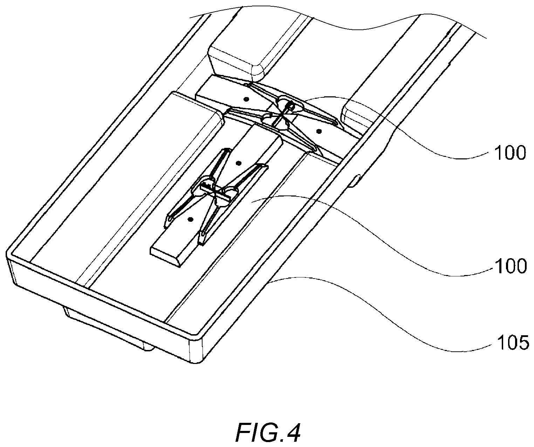

Fig. 4 illustrates two apparatuses 100, which are fixed inside a mold 105, according to the present invention. The mold 105 can be used in combination with the apparatus 100 to provide a network of data. In the mold 105 illustrated in Fig. 4, the two apparatuses are disposed to be perpendicular to each other. With this arrangement, a vertical read value and a horizontal read value of the strength of the magnetic field inside the material are provided. The apparatuses 100 can be disposed in various directions to acquire the data of the magnetic field strength in those directions. The examples illustrated are not to be construed as limited, and other arrangements are to be assumed easily.

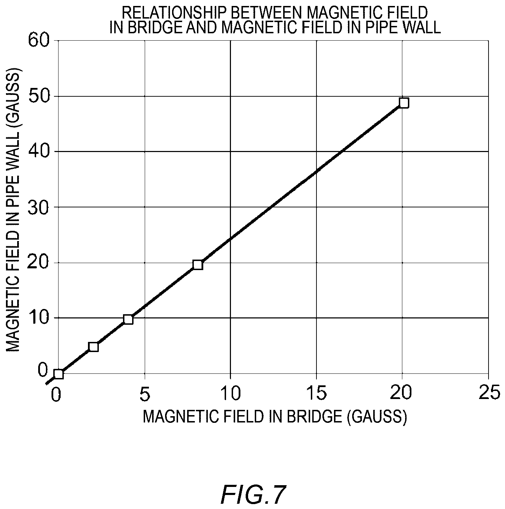

Fig. 7 is a graph illustrating a relationship between the strength of the magnetic field in the apparatus according to the present invention and the strength of the magnetic field in the sample under measurement. The strength of the magnetic field through the magnetic field strength measuring device 106 (bridge) is shown in Gaussian on an X-axis and the strength of the magnetic field through the sample 102 (pipe wall) on a Y-axis. The strength of the magnetic field inside the sample varies along different directions. For example, in the longitudinal direction of the sample, a higher magnetic field strength than in the lateral direction can exist. By using a plurality of apparatuses, the magnetic field strength can be measured in all orientations and directions. The relationship between the strength of the magnetic field inside the sample and the strength of the magnetic field inside the elongated member is always proportional. As a result, the apparatus can measure the strength of the magnetic field inside the sample in a non-destructive manner.

As shown, there is a direct proportional relationship between the strength of the magnetic field in the magnetic field strength measuring device 106 (bridge) and the sample 102 (pipe wall). The gradient of a line in the graph depends on the size and shape of the apparatus 100 and the size and shape of the sample 102. This is due to this relationship in which the present invention can be used. Since this relationship is linearly proportional, the apparatus 100 can continue to produce accurate measurement values without limitation. This relationship may not be a linear proportional relationship, but can be any other type of proportional relationship. The positive values of the magnetic field are shown. However, when the magnetic fields in the pipe wall are in diametrically opposite directions, the measured magnetic field is negative.

While certain embodiment of the present invention has been described above, it is understood that those departing from the described embodiment can still fall within the scope of the present invention.

### EXPLANATION OF REFERENCES

100 Apparatus
102 Sample
104 Housing
105 Mold
106 Magnetic field strength measuring device
108 Sensor
110 Elongated member
112 End portion
113 Extending portion
114 End portion
116 Gap
118 Longitudinal axis
120 Tapered portion
122 Connection portion
1140 Contact surface
1141 Rising surface

## Claims

1. An apparatus for measuring and/or monitoring a strength of a magnetic field inside a sample, the apparatus comprising:
a fixing unit made of a non-magnetic material;
a magnetic field strength measuring device having a sensor; and
a first elongated member and a second elongated member, wherein
the first elongated member and the second elongated member are made of a material having a high relative magnetic permeability, and each of the first elongated member and the second elongated member has a first end portion and a second end portion, and
the fixing unit is configured to support the first elongated member and the second elongated member in a fixed posture such that the first end portion of the first elongated member and the first end portion of the second elongated member are positioned opposite to each other to form a gap, and the fixing unit is configured to support the sensor of the magnetic field strength measuring device inside the gap or substantially inside the gap.

2. The apparatus according to claim 1, wherein
each of the first elongated member and the second elongated member is disposed to exist on a surface of the sample or to be adjacent to the surface of the sample, each of the first elongated member and the second elongated member has a longitudinal axis, and a center of the longitudinal axis is substantially aligned with a center of a longitudinal axis of another elongated member.

3. The apparatus according to claim 1 or 2, wherein
the first end portions of the first elongated member and the second elongated member include tapered portions, so that an area of a cross section of the first elongated member and the second elongated member is reduced to be same or substantially same as an area of a cross section of the sensor on the magnetic field strength measuring device.

4. The apparatus according to any one of claims 1 to 3, wherein
each of the first elongated member and the second elongated member has a contact surface in surface contact with the sample on a side closer to the second end portion than the first end portion.

5. The apparatus according to claim 4, wherein
each of the first elongated member and the second elongated member has an extending portion which extends away from the sample between the first end portion and the second end portion.

6. The apparatus according to claim 5, wherein
the extending portion is spaced further away from the sample as the extending portion is closer to the first end portion.

7. The apparatus according to claim 5 or 6, wherein
the first elongated member and the second elongated member are wider at the contact surfaces compared with the extending portions.

8. The apparatus according to any one of claims 4 to 7, wherein
the contact surface is curved in a width direction of the first elongated member or the second elongated member having the contact surface.

9. The apparatus according to any one of claims 4 to 7, wherein
the contact surface is curved in a length direction of the first elongated member or the second elongated member having the contact surface.

10. The apparatus according to any one of claims 4 to 9, wherein
a magnetic resistance between the contact surface of the first elongated member and the contact surface of the second elongated member in the apparatus is smaller than a magnetic resistance between the contact surface of the first elongated member and the contact surface of the second elongated member in the sample.

11. The apparatus according to any one of claims 1 to 10, wherein
the sample is a metal conduit.

12. The apparatus according to any one of claims 1 to 11, wherein
the fixing unit is a housing.

13. The apparatus according to claim 12, wherein
the housing has at least one connection portion suitable for connecting cables.

14. The apparatus according to claim 12 or 13, wherein
the housing, the first elongated member, and the second elongated member are attached to the sample.

15. The apparatus according to any one of claims 1 to 14, further comprising:
a transmission unit configured to transmit measurement data of the magnetic field strength measuring device.

16. The apparatus according to any one of claims 1 to 15, wherein
the magnetic field strength measuring device has a Hall effect sensor.

17. The apparatus according to any one of claims 1 to 16, wherein
the first elongated member and the second elongated member are made of a material which also has a low relative residual magnetism of less than 100 microtesla.

18. The apparatus according to any one of claims 1 to 17, wherein
the magnetic field strength measuring device is configured to measure a magnetic field strength of about 0 to +/-15000 Gauss.

19. The apparatus according to any one of claims 1 to 18, wherein
a permeability of the first elongated member and the second elongated member is higher than a permeability of the sample.

20. A method for measuring and/or monitoring a strength of a magnetic field inside a sample, the method comprising:
attaching or disposing the apparatus according to any one of claims 1 to 19 on the sample;
measuring the strength of a magnetic field through the first elongated member and the second elongated member by using the magnetic field strength measuring device; and
monitoring a value of the strength of the magnetic field through the sample by monitoring a value of the strength of the magnetic field through the first elongated member and the second elongated member.

21. The method according to claim 20, further comprising:
establishing a relationship between the strength of the magnetic field in the first elongated member and the second elongated member and the strength of the magnetic field in the sample.

22. The method according to claim 20 or 21, wherein
the measuring and the monitoring the strength of the magnetic field inside the sample are performed to monitor an area of a cross section of the sample.

23. The method according to any one of claims 20 to 22, wherein
the apparatus is attached to the sample in a state where longitudinal axes of the first elongated member and the second elongated member are aligned with a first axis of the sample, so that the strength of the magnetic field through the sample is measured and monitored in a same direction as the first axis.
